# EUROPEAN PATENT APPLICATION

(11) **EP 4 770 343 A1**
(43) Date of publication of application: **01.07.2026**
(21) Application number: 25770639.0
(22) Date of filing: 16.05.2025
(51) Int. Cl.: H10F 19/85

(54) **CURVED PHOTOVOLTAIC TILE AND MANUFACTURING METHOD THEREFOR**

(30) Priority: 30.10.2024 CN 202411535912
(71) Applicant: Shenzhen Hello Tech Energy Co., Ltd, Shenzhen, Guangdong 518109 (CN)
(72) Inventor: GU, Hongyang, Shenzhen, Guangdong 518109 (CN); YU, Huajun, Shenzhen, Guangdong 518109 (CN); ZHU, Yanjun, Shenzhen, Guangdong 518109 (CN); WANG, Linqiang, Shenzhen, Guangdong 518109 (CN); HAN, Yingjie, Shenzhen, Guangdong 518109 (CN)
(74) Representative: advotec.
(86) International application number: PCT/CN2025/095327
(87) International publication number: WO 2026/091479

(57) **Abstract**

A curved photovoltaic tile (100) and a manufacturing method thereof. The method includes: providing a curved assembly (10), wherein the curved assembly (10) includes a curved backsheet (11), a first adhesive (12) and curved solar cells (13), and the first adhesive (12) connects the curved backsheet (11) and the curved solar cells (13); and stacking and fixing the curved assembly (10) and a curved panel (20), wherein the curved assembly (10) has a same shape as the curved panel (20).

## Description

### PRIORITY INFORMATION

The present application claims the priority to and benefit of the patent application NO. 202411535912.9, filed with the China National Intellectual Property Administration on October 30, 2024, the content of which is incorporated herein by reference in its entirety.

### TECHNICAL FIELD

The present application relates to the field of photovoltaic technologies, and in particular to, a curved photovoltaic tile and a manufacturing method thereof.

### BACKGROUND

With the highlighting of severe problems such as energy shortage and climate emission, various countries in the world pay more and more attention to clean and pollution-free renewable energy sources. Solar energy is an inexhaustible green energy source. At present, the application fields of photovoltaic power generation are extensive, the design of building integrated photovoltaics (BIPV) gradually becomes a trend, and residential roofs are the main application areas of distributed photovoltaic power generation. A photovoltaic tile is usually formed by laminating tempered glass and solar cells, then assembling an aluminum frame for framing, and finally sealing edge portions with silicone. However, the inventors believe that when flat glass and flat solar cells are laminated to form a curved photovoltaic tile, microcracks easily occur in the solar cells, resulting in product failure.

### SUMMARY

The present application aims to solve at least one of the technical problems existing in the prior art or related art.

To this end, the present disclosure provides a method for manufacturing a curved photovoltaic tile, including:
providing a curved assembly, where the curved assembly comprises a curved backsheet, a first adhesive and curved solar cells, and the first adhesive connects the curved backsheet and the curved solar cells; and
stacking and fixing the curved assembly and a curved panel, where the curved assembly has a same shape as the curved panel.

In this way, by obtaining the curved assembly having the same shape as the curved panel and then stacking and fixing the curved assembly and the curved panel, the pressure required for stacking and fixing the curved backsheet, the curved solar cells and the curved panel to form the curved photovoltaic tile can be reduced, thereby reducing the phenomenon of microcracks in the curved solar cells and improving the production yield of the curved photovoltaic tile.

The present disclosure further provides a curved photovoltaic tile, where the curved photovoltaic tile is manufactured by using the above manufacturing method.

Additional aspects and advantages of the present application will be partly set forth in the following description, partly become apparent from the following description, or be learned through the practice of the present application.

### BRIEF DESCRIPTION OF DRAWINGS

The above-described and/or additional aspects and advantages of the present application will become apparent and readily understandable from the description of the embodiments in conjunction with the accompanying drawings below, in which:
FIG. 1 is a schematic structural diagram of a curved photovoltaic tile according to an embodiment of the present application;
FIG. 2 is a schematic exploded structural diagram of a curved photovoltaic tile according to an embodiment of the present application;
FIG. 3 is a schematic structural diagram of a curved photovoltaic tile according to an embodiment of the present application;
FIG. 4 is a schematic flowchart of a manufacturing method of a curved photovoltaic tile according to an embodiment of the present application;
FIG. 5 is a schematic diagram of a manufacturing process of a curved photovoltaic tile according to an embodiment of the present application;
FIG. 6 is a schematic flowchart of a manufacturing method of a curved photovoltaic tile according to an embodiment of the present disclosure; and
FIG. 7 is a schematic flowchart of a manufacturing method of a curved photovoltaic tile according to an embodiment of the present disclosure.

Description of Reference Signs: 100, curved photovoltaic tile; 10, curved assembly; 11, curved backsheet; 12, first adhesive; 13, curved solar cell; 20, curved panel; 30, flat assembly; 31, flat backsheet; 32, flat solar cell; 33, encapsulation layer; 34, ribbon; 40, second adhesive.

### DESCRIPTION OF EMBODIMENTS

In order to more clearly understand the above objects, features and advantages of the present application, the present application is further described in detail below in conjunction with the accompanying drawings and specific embodiments. It should be noted that the examples of the present application and the features in the embodiments can be combined with each other, unless conflict occurs.

Many specific details are set forth in the following description to facilitate a full understanding of the present application, but the present application may also be implemented in other manners different from those described herein, and therefore, the protection scope of the present application is not limited by the specific embodiments disclosed below.

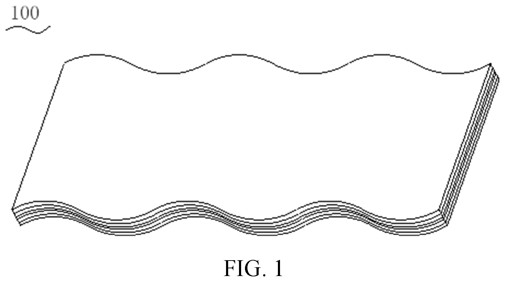

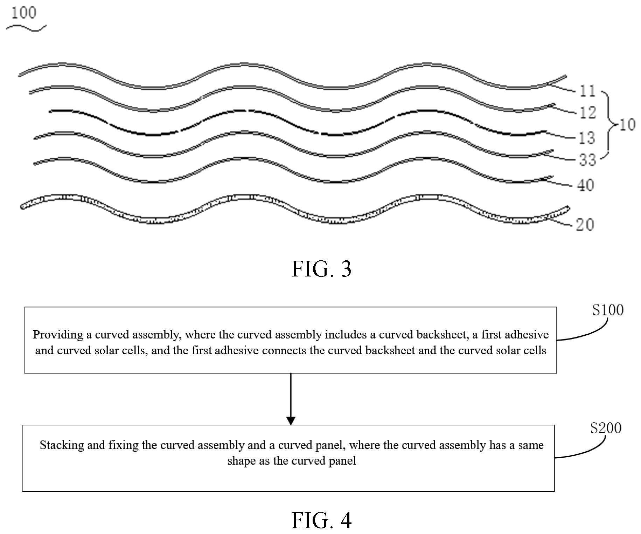

Referring to FIG. 1 to FIG. 5, a manufacturing method of a curved photovoltaic tile 100 according to an embodiment of the present disclosure includes:
S100, providing a curved assembly 10, where the curved assembly 10 includes a curved backsheet 11, a first adhesive 12 and curved solar cells 13, and the first adhesive 12 connects the curved backsheet 11 and the curved solar cells 13; and
S200, stacking and fixing the curved assembly 10 and a curved panel 20, where the curved assembly 10 has a same shape as the curved panel 20.

In this way, by obtaining the curved assembly 10 having the same shape as the curved panel 20 and then stacking and fixing the curved assembly 10 and the curved panel 20, the pressure required for stacking and fixing the curved backsheet 11, the curved solar cells 13 and the curved panel 20 to form the curved photovoltaic tile 100 can be reduced, thereby reducing the phenomenon of microcracks in the curved solar cells 13 and improving the production yield of the curved photovoltaic tile 100.

Specifically, the curved photovoltaic tile 100 is a type of roof tile capable of converting solar energy into electrical energy, and the curved photovoltaic tile 100 can not only be additionally installed on an existing roof surface, but also be used as a building member, that is, building integrated photovoltaic application. The curved photovoltaic tile 100 can be applied to flat or vertical installation.

The curved panel 20 and the curved backsheet 11 form an outermost layer of the curved photovoltaic tile 100, which can play the role of sealing, insulating and protecting the curved solar cells 13, thereby improving the mechanical performance of the curved photovoltaic tile 100. The curved panel 20 and the curved backsheet 11 can protect the curved solar cells 13 from damage to the curved solar cells 13 caused by climate changes, for example, high temperature, low temperature, rain or hail, etc., and can also protect the curved solar cells 13 from damage caused by collisions and the like during transportation, which effectively improve the ability of the curved photovoltaic tile 100 to cope with harsh environments.

The outer layer material of a back surface of the curved photovoltaic tile 100 is referred to as the curved backsheet 11, which is a key component of the curved photovoltaic tile 100, and the curved backsheet 11 isolates the curved solar cells 13 from the external environment to realize insulation, enabling the cells to operate outdoors for a long time. Curved backsheets 11 with different structures have different functions, and suitable curved backsheets 11 can be selected according to different use areas, for example, fluorine-containing backsheets can be used in areas with strong ultraviolet rays, white backsheets can enhance light reflection and improve power generation efficiency, black backsheets can meet the aesthetic requirements of roofs, and glass backsheets have higher light transmittance.

The main role of the curved solar cells 13 is to generate electricity, and the curved solar cells 13 may be crystalline silicon solar cells, which have relatively lower equipment cost and higher photoelectric conversion efficiency, and are suitable for generating electricity under outdoor sunlight.

The curved panel 20 may be made of a light-transmitting material, for example, curved glass, and a light-transmitting curved panel 20 has good light transmittance. The curved panel 20 includes a light-receiving surface and a backlight surface, the curved panel 20 serves as a front surface of the curved photovoltaic tile 100, and sunlight can pass through the light-receiving surface of the curved panel 20 to irradiate the curved solar cells 13, facilitating the curved solar cells 13 to receive light and to convert solar energy into electrical energy.

The first adhesive 12 can bond the curved backsheet 11 and the curved solar cells 13 together, thereby improving the stability and reliability of the curved assembly 10. The first adhesive 12 may use an ethylene vinyl acetate (EVA) material, a thermoplastic polyolefin (TPO) material, a polyvinyl butyral (PVB) material, or a polyolefin elastomer (POE) material, to ensure encapsulation performance, light transmittance and so on of the first adhesive 12, thereby ensuring power generation efficiency of the curved photovoltaic tile 100.

The shape of the curved assembly 10 is the same as the shape of the curved panel 20, for example, both the curved assembly 10 and the curved panel 20 are arched or wavy, and the undulation radian of their connecting surface is consistent.

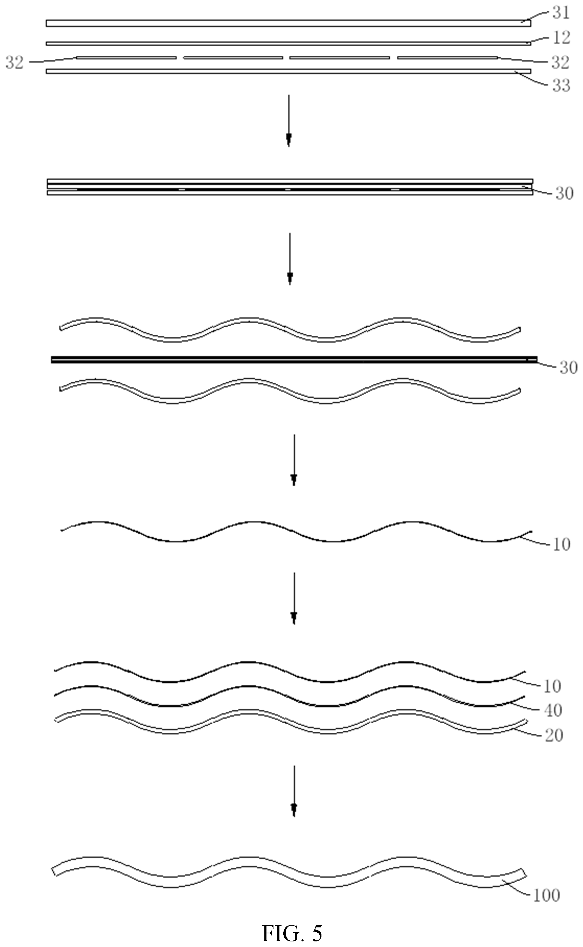

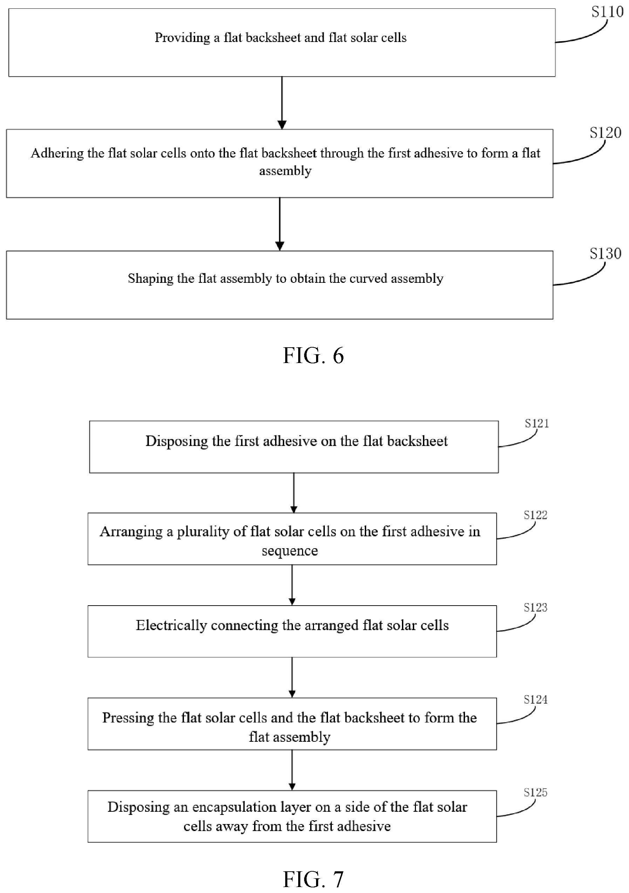

Referring to FIG. 5 and FIG. 6, in some embodiments, said providing a curved assembly 10 (step S100) includes:
S110, providing a flat backsheet 31 and flat solar cells 32;
S120, adhering the flat solar cells 32 onto the flat backsheet 31 through the first adhesive 12 to form a flat assembly 30;
S130, shaping the flat assembly 30 to obtain the curved assembly 10.

In this way, the curved assembly 10 can be obtained through the above steps.

Specifically, the curved backsheet 11 can be obtained after shaping the flat backsheet 31, and the curved solar cells 13 can be obtained after shaping the flat solar cells 32.

The flat backsheet 31 may be made of a flexible polymer material, for example, PET, CPC, HPC, etc., so that the flat backsheet 31 can be bent into different shapes, which is suitable for different design requirements.

The flat solar cell 32 is preferably one of the cells among XBC, MWT, and shingled cells that have no metal grid lines and have both positive and negative metal electrodes led out from the back surface, and is secondarily preferably a solar cell with grid lines on both front and back surfaces, such as one of PERC and TOPCON. This can maintain the consistency of the appearance of the flat solar cell 32, and avoid metal grid lines and metal electrodes affecting the front appearance of the flat solar cell 32, thereby improving aesthetics.

The first adhesive 12 may first be adhered onto the flat backsheet 31, and then the flat solar cells 32 may be adhered onto the first adhesive 12. Alternatively, the first adhesive 12 may first be adhered onto the flat solar cells 32, and then the flat backsheet 31 may be adhered onto the first adhesive 12.

Referring to FIG. 5 and FIG. 7, in some embodiments, said adhering the flat solar cells 32 onto the flat backsheet 31 through the first adhesive 12 to form a flat assembly 30 (step S120) includes:
S121, disposing the first adhesive 12 on the flat backsheet 31;
S122, arranging a plurality of flat solar cells 32 on the first adhesive 12 in sequence;
S123, electrically connecting the arranged flat solar cells 32;
S124, pressing the flat solar cells 32 and the flat backsheet 31 to form the flat assembly 30.

In this way, through the above steps, the flat solar cells 32 can be adhered onto the flat backsheet 31 to form the flat assembly 30.

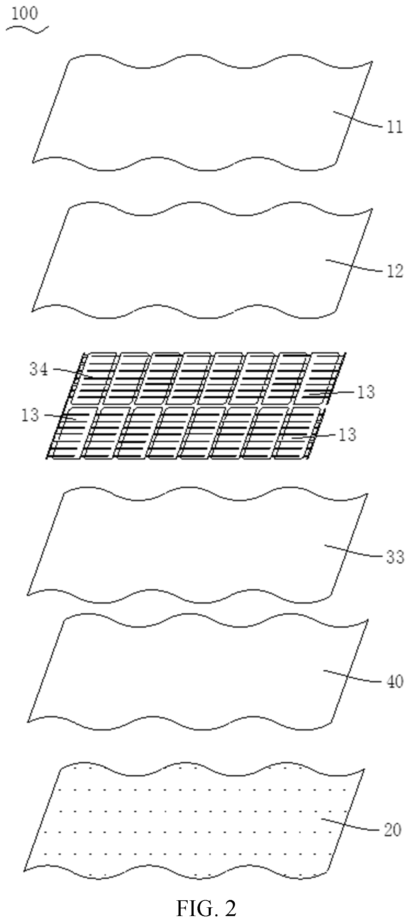

Specifically, with reference to FIG. 2, the plurality of flat solar cells 32 can be arranged in a rectangular pattern. The flat solar cells 32 can be welded by using ribbons, a positive (or negative) electrode on the back surface of a previous flat solar cell 32 is connected to a negative (or positive) electrode on the front surface of a next flat solar cell 32, and they are heated to be welded together, and so on, to connect all the flat solar cells 32 in series.

A flat laminator can be used to press the flat solar cells 32 and the flat backsheet 31 to form the flat assembly 30. In one example, a vacuum environment can be created by evacuating through vacuum equipment; the flat backsheet 31, the first adhesive 12, and the flat solar cells 32 are placed in sequence; and the flat backsheet 31 can be pushed by the laminator. For example, the laminator can press the flat backsheet 31 down flatly toward the first adhesive 12 and the flat solar cells 32 through a flat silicone layer, thereby forming the flat assembly 30.

In some embodiments, said pressing the flat solar cells 32 and the flat backsheet 31 to form the flat assembly 30 includes:
pressing and fixing the flat solar cells 32 and the flat backsheet 31 by means of multi-stage pressing, where a pressing temperature increases stage by stage.
fixing the flat solar cells 32 and the flat backsheet 31 together by means of multi-stage pressing, the temperature of each pressing stage increases progressively.

In this way, pressing and fixing the flat solar cells 32 and the flat backsheet 31 to form the flat assembly 10 by means of multi-stage pressing can improve the stability of the first adhesive 12, and facilitate the formation of a stable bond between the flat solar cells 32 and the flat backsheet 31, thereby improving the stability and reliability of the flat assembly 30.

The pressing temperature refers to the temperature applied by the laminator during the pressing process. In one embodiment, the pressing process for pressing the flat solar cells 32 and the flat backsheet 31 to form the flat assembly 30 is divided into four stages: a first stage has a pressing temperature of 80°C to 90°C and a pressing time of 5 minutes to 10 minutes; a second stage has a pressing temperature of 100°C to 110°C and a pressing time of 5 minutes to 10 minutes; a third stage has a pressing temperature of 120°C to 130°C and a pressing time of 5 minutes to 10 minutes; and a fourth stage has a pressing temperature of 150°C to 160°C and a pressing time of 40 minutes to 60 minutes.

In some embodiments, the pressing pressure for pressing the flat solar cells 32 and the flat backsheet 31 to form the flat assembly 30 is -99 kPa to -100 kPa.

In this way, the flat solar cells 32 and the flat backsheet 31 are pressed and fixed by the negative pressure within the above pressure range to form the flat assembly 30, which can increase an acting force between the flat solar cells 32 and the flat backsheet 31, thereby improving the stability and reliability of the flat assembly 30.

Specifically, the pressing pressure is a vertical force applied by the laminator to the flat solar cells 32 and the flat backsheet 31, and the pressing pressure may be -99 kPa, -99.2 kPa, -99.4 kPa, -99.6 kPa, -99.8 kPa, -100 kPa, or the like.

Referring to FIG. 5 and FIG. 7, in some embodiments, said adhering the flat solar cells 32 onto the flat backsheet 31 through the first adhesive 12 to form a flat assembly 30 (step S120) further includes:
S125, disposing an encapsulation layer 33 on a side of the flat solar cells 32 away from the first adhesive 12.

In this way, the encapsulation layer 33 can play the role of buffering during the shaping of the flat assembly 30, thereby lowering the risk of fragmentation of the flat solar cells 32.

Specifically, the material of the encapsulation layer 33 and the material of the first adhesive 12 may be the same or different. For example, both the encapsulation layer 33 and the first adhesive 12 are made of an EVA material. For another example, the encapsulation layer 33 is made of a TPO material, and the first adhesive 12 is made of a PVB material.

Referring to FIG. 5, in some embodiments, shaping the flat assembly 30 to obtain the curved assembly 10 includes:
pressing the flat assembly 30 at a preset temperature using shaping tooling to obtain the curved assembly 10.

In this way, the flat assembly 30 is shaped by the shaping tooling, so that the curved assembly 10 obtained after shaping has the same as the curved panel 20.

Specifically, a surface shape of the shaping tooling can be designed according to a surface shape of the curved panel 20, and the pressure and temperature during shaping can be designed according to the degree of curvature of the curved panel 20 and the material of each component in the curved assembly 10.

Referring to FIG. 5, in some embodiments, said stacking and fixing the curved assembly 10 and a curved panel 20 includes:
stacking and disposing a second adhesive 40 and the curved panel 20 on a side of the curved solar cells 13 of the curved assembly 10 away from the curved backsheet 11, and pressing the curved assembly 10 and the curved panel 20.

In this way, the curved assembly 10 and the curved panel 20 can be connected through the second adhesive 40; furthermore, the second adhesive 40 can protect the side of the curved solar cells 13 away from the curved backsheet 11 from being in hard contact with the curved panel 20, thereby lowering the risk of microcracks in the curved solar cells 13.

In an example, a vacuum environment can be created by evacuating through vacuum equipment, and the laminator can form a mold having the same shape as the curved assembly 10 through mold opening to stably fix the curved assembly 10 and then to press and fix the curved panel 20 toward the second adhesive 40 and the curved assembly 10, thereby forming the curved photovoltaic tile 100.

In some embodiments, said pressing the curved assembly 10 and the curved panel 20 includes:
pressing and fixing the curved assembly 10 and the curved panel 20 by means of multi-stage pressing, where a pressing pressure increases stage by stage.

In this way, pressing and fixing the curved assembly 10 and the curved panel 20 to form the curved photovoltaic tile 100 by means of multi-stage pressing can increase an acting force between the curved assembly 10 and the curved panel 20, thereby improving the stability and the reliability of the curved photovoltaic tile 100.

In one embodiment, the pressing process of pressing and fixing the curved assembly 10 and the curved panel 20 is divided into three stages: a first stage has a pressing pressure of - 80 kPa to -70 kPa and a pressing time of 30 s to 60 s; a second stage has a pressing pressure of -60 kPa to -50 kPa and a pressing time of 30 s to 60 s; and a third stage has a pressing pressure of -40 kPa to 0 kPa and a pressing time of 15 s to 20 s. The temperature for all three stages of pressing is 140°C to 150°C.

Referring to FIG. 5, the curved photovoltaic tile 100 according to an embodiment of the present application is manufactured by using the above manufacturing method, including:
S100, providing a curved assembly 10, where the curved assembly 10 includes a curved backsheet 11, a first adhesive 12 and curved solar cells 13, and the first adhesive 12 connects the curved backsheet 11 and the curved solar cells 13; and
S200, stacking and fixing the curved assembly 10 and a curved panel 20, where the curved assembly 10 has a same shape as the curved panel 20.

The primary pressing of the flat backsheet 31, the first adhesive 12, and the flat solar cells 32 is performed to form the flat assembly 30, then the flat assembly 30 is shaped to obtain the curved assembly 10 having the same shape as the curved panel 20, and finally the secondary pressing of the curved assembly 10 and the curved panel 20 is performed to form the curved photovoltaic tile 100. Since the shape of the flat solar cells 32 after shaping is the same as the shape of the curved panel 20, the pressure for the secondary pressing of the curved assembly 10 and the curved panel 20 can be reduced, thereby reducing the phenomenon of microcracks in the curved solar cells 13 and improving the production yield of the curved photovoltaic tile 100.

In the description of this specification, descriptions made with references to terms such as "one embodiment", "some embodiments", "exemplary embodiments", "examples", "specific examples", or "some examples" mean that the specific features, structures, materials, or characteristics described in connection with the embodiment or example are included in at least one embodiment or example of the present application. In this specification, the schematic representations of the above terms do not necessarily refer to the same embodiment or example. Moreover, the specific features, structures, materials, or characteristics described may be combined in any suitable manner in one or more embodiments or examples.

Although the embodiments of the present application have been shown and described, those of ordinary skill in the art can understand that various changes, modifications, substitutions, and variations may be made to these embodiments without departing from the principles and purposes of the present application, and the scope of the present application is defined by the claims and their equivalents.

## Claims

1. A method for manufacturing a curved photovoltaic tile, comprising:
providing a curved assembly, wherein the curved assembly comprises a curved backsheet, a first adhesive and curved solar cells, and the first adhesive connects the curved backsheet and the curved solar cells; and
stacking and fixing the curved assembly and a curved panel, wherein the curved assembly has a same shape as the curved panel.

2. The manufacturing method according to claim 1, wherein said providing a curved assembly comprises:
providing a flat backsheet and flat solar cells;
adhering the flat solar cells onto the flat backsheet through the first adhesive to form a flat assembly; and
shaping the flat assembly to obtain the curved assembly.

3. The manufacturing method according to claim 2, wherein said adhering the flat solar cells onto the flat backsheet through the first adhesive to form a flat assembly comprises:
disposing the first adhesive on the flat backsheet;
arranging a plurality of flat solar cells on the first adhesive in sequence;
electrically connecting the arranged flat solar cells;
pressing the flat solar cells and the flat backsheet to form the flat assembly.

4. The manufacturing method according to claim 3, wherein said pressing the flat solar cells and the flat backsheet to form the flat assembly comprises:
pressing and fixing the flat solar cells and the flat backsheet by means of multi-stage pressing, wherein a pressing temperature increases stage by stage.

5. The manufacturing method according to claim 4, wherein the pressing temperature for pressing and fixing the flat solar cells and the flat backsheet is 80°C to 160°C.

6. The manufacturing method according to claim 4, wherein a pressing time for pressing and fixing the flat solar cells and the flat backsheet is 5 minutes to 60 minutes.

7. The manufacturing method according to claim 3, wherein a pressing pressure for pressing the flat solar cells and the flat backsheet to form the flat assembly is -99 kPa to -100 kPa.

8. The manufacturing method according to claim 2, wherein said adhering the flat solar cells onto the flat backsheet through the first adhesive to form a flat assembly further comprises:
disposing an encapsulation layer on a side of the flat solar cells away from the first adhesive.

9. The manufacturing method according to claim 2, wherein said shaping the flat assembly to obtain the curved assembly comprises:
pressing the flat assembly at a preset temperature using shaping tooling to obtain the curved assembly.

10. The manufacturing method according to claim 1, wherein said stacking and fixing the curved assembly and a curved panel comprises:
stacking and disposing a second adhesive and the curved panel on a side of the curved solar cells of the curved assembly away from the curved backsheet, and pressing the curved assembly and the curved panel.

11. The manufacturing method according to claim 10, wherein said pressing the curved assembly and the curved panel comprises:
pressing and fixing the curved assembly and the curved panel by means of multi-stage pressing, wherein a pressing pressure increases stage by stage.

12. The manufacturing method according to claim 11, wherein a pressing pressure for pressing and fixing the curved assembly and the curved panel is -80 kPa to 0 kPa.

13. The manufacturing method according to claim 11, wherein a pressing time for pressing and fixing the curved assembly and the curved panel is 15 s to 60 s.

14. The manufacturing method according to any one of claims 1 to 13, wherein the curved solar cells are crystalline silicon solar cells.

15. The manufacturing method according to any one of claims 1 to 14, wherein the curved panel is made of a light-transmitting material.

16. The manufacturing method according to claim 2, wherein the flat backsheet is made of a flexible polymer material.

17. A curved photovoltaic tile, wherein the curved photovoltaic tile is manufactured by using the manufacturing method according to any one of claims 1 to 16.

18. The curved photovoltaic tile according to claim 17, wherein the curved solar cells are crystalline silicon solar cells.

19. The curved photovoltaic tile according to claim 17 or 18, wherein the curved panel is made of a light-transmitting material.

20. The curved photovoltaic tile according to any one of claims 17 to 19, wherein the backsheet is made of a flexible polymer material.
